# EUROPÄISCHE PATENTSCHRIFT

(11) **EP 3 028 551 B1**
(45) Veröffentlichungstag und Bekanntmachung des Hinweises auf die Patenterteilung: **14.06.2017**
(21) Anmeldenummer: 14742221.6
(22) Anmeldetag: 24.07.2014
(51) Int. Cl.: H05K 5/00, H05K 3/28, B29C 45/14, H05K 5/06, H05K 1/14

(54) **ELEKTRONIKMODUL MIT LEITERPLATTEN UND ANSPRITZBAREM KUNSTSTOFF-DICHTRING, INSBESONDERE FÜR EIN KFZ-GETRIEBESTEUERGERÄT, UND VERFAHREN ZUM FERTIGEN DESSELBEN**
ELECTRONIC MODULE HAVING CIRCUIT BOARDS AND A PLASTIC SEALING RING THAT CAN BE MOLDED ON BY INJECTION MOLDING, IN PARTICULAR FOR A MOTOR VEHICLE TRANSMISSION CONTROL UNIT, AND METHOD FOR PRODUCING SAID ELECTRONIC MODULE
MODULE ÉLECTRONIQUE AVEC CIRCUITS IMPRIMÉS ET BAGUE D'ÉTANCHÉITÉ EN MATIÈRE PLASTIQUE PULVÉRISABLE, NOTAMMENT POUR UN CONTRÔLEUR DE BOÎTE DE VITESSES DE VÉHICULE AUTOMOBILE, ET PROCÉDÉ POUR SA FABRICATION

(30) Priorität: 02.08.2013 DE 102013215246
(43) Veröffentlichungstag der Anmeldung: 08.06.2016
(73) Patentinhaber: Robert Bosch GmbH, 70442 Stuttgart (DE)
(72) Erfinder: LISKOW, Uwe, 71679 Asperg (DE)
(86) Internationale Anmeldenummer: PCT/EP2014/065872
(87) Internationale Veröffentlichungsnummer: WO 2015/014697

(56) Entgegenhaltungen:
- EP-A1- 2 163 145
- EP-A1- 2 305 013
- DE-A1- 3 942 392
- DE-A1-102009 053 512
- US-A1- 2008 170 372

## Beschreibung

### Gebiet der Erfindung

Die vorliegende Erfindung betrifft ein Elektronikmodul, wie es insbesondere für ein Getriebesteuergerät in einem Kraftfahrzeug eingesetzt werden kann. Die Erfindung betrifft ferner ein Verfahren zum Fertigen eines solchen Elektronikmoduls.

### Stand der Technik

Steuergeräte wie zum Beispiel Getriebesteuergeräte (TCU - transmission control unit), Motorsteuergeräte, Batteriesteuergeräte, etc. in einem Kraftfahrzeug, die elektronische Bauelemente enthalten, sollten im Allgemeinen hermetisch dicht gegen umgebende Medien geschützt werden. Bei Anwendungen in Kraftfahrzeugen können solche Steuergeräte beispielsweise aggressiven Medien wie Getriebeöl, Motoröl, Wasser, Harnstoff-Wasser-Lösungen, Bremsflüssigkeit usw. ausgesetzt sein. Hinzu kommt, dass Steuergeräte insbesondere beim Einsatz in Kraftfahrzeugen weiteren potenziell schädigenden Einflüssen wie beispielweise starken Temperaturschwankungen, mechanischen Vibrationsbelastungen, etc. ausgesetzt sein können.

Um die elektronischen Bauelemente von Kfz-Steuergeräten vor schädigenden Einflüssen, insbesondere durch umgebende Medien, schützen zu können, werden diese bisher meist in aufwändig ausgestalteten, hermetisch abdichtenden Gehäusen aufgenommen. Die Gehäuse bestehen dabei meist aus Metallblech, wobei z.B. durch eine Gehäusewand durchzuführende elektrische Leitungen aufwändig elektrisch isoliert werden müssen. Ein Aufwand für die Fertigung des Gehäuses sowie für die elektrische Isolation der Zuleitungen kann erheblich sein. Einfachere, kostengünstigere technische Lösungen haben sich bisher häufig nicht als langfristig zuverlässig erwiesen. Beispielsweise wurde beobachtet, dass Dichtungen in Form von Elastomerringen, die zum hermetischen Abdichten von komplementäre Teilen eines Kunststoffgehäuses eingesetzt wurden, den bei Kfz-Anwendungen auftretenden harten Umgebungsbedingungen, insbesondere den aggressiven Umgebungsmedien, nicht langfristig, beispielsweise über mehr als zehn Jahre, widerstehen können. Um die in dem Gehäuse aufgenommenen elektronischen Bauteile zusätzlich gegen eventuell eindringende Medien zu schützen, werden diese oft mit einem schützenden Gel umgeben, wodurch jedoch zusätzlicher Aufwand und Kosten entstehen.

Alternative Ansätze, bei denen sogenannte Stanzgitter mit einem Kunststoff umformt werden, erfordern z.B. teure Spitzgusswerkzeuge.

DE 10 2004 021 931 A1 beschreibt ein Gehäuse für eine elektronische Schaltung.

Aus der DE 39 42 392 A1 ist ein Elektronikmodul mit den Merkmalen des Oberbegriffs des Anspruchs 1 bekannt.

Aus der EP 2 163 145 A1 und aus der EP 2 305 013 A1 sind Elektronikmodule mit zwei Leiterplattenelementen, einem Abstandshalter und einem inneren Montageraum für elektronische Bauelemente bekannt, wobei eine Abdichtung mittels einer Moldmasse erfolgt.

Aus der DE 10 2009 053512 A1 ist die Herstellung eines Verbundteils bekannt, wobei die Haftung zwischen einem Bauteil und einem aushörbaren Material durch Einbringen einer Mikrostrukturierung in die Oberfläche des Bauteils verbessert wird.

Die US 2008/170372A1 offenbart ein Elektronikmodul mit einer Leiterplatte, wobei die Leiterplatte mittels eines Gussharzes eingefasst ist, Zur Verbesserung der Haftung ist die Oberfläche der Leiterplatte aufgeraut.

### Offenbarung der Erfindung

Mit Ausführungsformen der vorliegenden Erfindung wird ein Elektronikmodul beziehungsweise ein Verfahren zum Fertigen eines solchen Elektronikmoduls beschrieben, mithilfe derer sich eine einfache und kostengünstige Herstellbarkeit mit einer langen, zuverlässigen Haltbarkeit von Elektronikmodulen insbesondere für den Fahrzeugbau kombinieren lassen. Insbesondere werden ein vorteilhaftes Elektronikmodul und ein Verfahren zu dessen Fertigung beschrieben, bei dem elektronische Bauteile, die in dem Elektronikmodul aufgenommen sind, langfristig zuverlässig hermetisch dicht gegenüber aggressiven umgebenden Medien geschützt sind.

Gemäß einem ersten Aspekt der vorliegenden Erfindung wird ein Elektronikmodul vorgeschlagen, dass ein erstes und ein zweites Leiterplattenelement sowie einen Abstandhalter aufweist. Das erste Leiterplattenelement ist mit wenigstens einem daran angeordneten elektronischen Bauelement wie z.B. einer elektronischen Steuerungsschaltung versehen. Das zweite Leiterplattenelement ist mit wenigstens einem daran angeordneten elektrischen Bauelement wie z.B. einem Steckeranschluss, einem Sensor, etc. versehen. Das erste Leiterplattenelement, das zweite Leiterplattenelement und der Abstandhalter sind derart komplementär zueinander ausgebildet, dass sie gemeinsam einen zentralen Hohlraum, in dem das elektronische Bauelement des ersten Leiterplattenelements aufgenommen ist, vollständig umhüllen. Das Elektronikmodul zeichnet sich dadurch aus, dass sowohl an einer nach außen gerichteten Oberfläche des ersten Leiterplattenelements an einem äußeren Umfang des ersten Leiterplattenelements als auch an einer nach außen gerichteten Oberfläche des zweiten Leiterplattenelements benachbart zu dem äußeren Umfang des ersten Leiterplattenelements jeweils ringförmig umlaufend eine Mikrostrukturierung ausgebildet ist. Ferner ist entlang des äußeren Umfangs des ersten Leiterplattenelements ein Dichtring ausgebildet, der in formschlüssiger Verbindung sowohl mit der an dem ersten Leiterplattenelement ausgebildeten Mikrostrukturierung als auch in formschlüssiger Verbindung mit der an dem zweiten Leiterplattenelement ausgebildeten Mikrostrukturierung steht.

Gemäß einem zweiten Aspekt der vorliegenden Erfindung wird ein Verfahren zum Fertigen eines Elektronikmoduls, insbesondere eines Elektronikmoduls gemäß dem obigen ersten Aspekt der vorliegenden Erfindung, beschrieben. Dabei werden zuerst das erste und das zweite Leiterplattenelement sowie der Abstandhalter bereit gestellt. Dann wird sowohl an einer nach außen gerichteten Oberfläche des ersten Leiterplattenelements an einem äußeren Umfang des ersten Leiterplattenelements als auch an einer nach außen gerichteten Oberfläche des zweiten Leiterplattenelements benachbart zu dem äußeren Umfang des ersten Leiterplattenelements eine ringförmig umlaufende Mikrostrukturierung ausgebildet. Anschließend wird wenigstens ein elektronisches Bauelement an einer zu dem zentralen Hohlraum, der von den beiden Leiterplattenelementen und dem Abstandhalter umschlossen wird, gerichteten Oberfläche des ersten Leiterplattenelements angeordnet. Danach wird ein Dichtring entlang des äußeren Umfangs des ersten Leiterplattenelements derart ausgebildet, dass der Dichtring in formschlüssiger Verbindung sowohl mit der an dem ersten Leiterplattenelement ausgebildeten Mikrostrukturierung als auch in formschlüssiger Verbindung mit der an dem zweiten Leiterplattenelement ausgebildeten Mikrostrukturierung steht.

Ideen zu Ausführungsformen der vorliegenden Erfindung können unter anderem als auf den nachfolgend beschriebenen Gedanken und Erkenntnissen beruhend angesehen werden.

Bisherige technische Lösungen zur hermetisch dichten Verkapselung von elektronischen Bauelementen in einem Elektronikmodul mithilfe eines separat vorgesehenen Gehäuses wurden als kostenintensiv und aufwändig in der Herstellung erkannt. Auch ein Umspritzen von beispielsweise mit elektronischen Bauelementen versehenen Stanzgittern mittels einer Kunststoffumspritzung ist kostenintensiv aufgrund der hierfür notwendigen teuren Spritzwerkzeuge. Technisch einfachere Lösungen mit beispielsweise aus Kunststoff bestehenden Gehäuseteilen und herkömmlichen zwischen solchen Gehäuseteilen angeordneten Dichtringen scheinen langfristig nicht zuverlässig abdichten zu können, so dass ein Schutz der elektronischen Bauelemente durch zusätzliche Maßnahmen wie beispielsweise ein Einfüllen eines chemisch resistenten Gels in Bereiche um die Bauelemente herum notwendig erscheint.

Es wurde nun erkannt, dass ein Elektronikmodul mit Hilfe von zwei vorzugsweise benachbart parallel zueinander angeordneten Leiterplattenelementen wie beispielsweise Platinen (PCB - printed circuit board) gebildet werden kann. Die beiden Leiterplattenelemente werden voneinander durch einen dazwischen angeordneten Abstandhalter beabstandet. Zusammen mit dem Abstandhalter umgeben die beiden Leiterplattenelemente einen zentralen Hohlraum, in dem elektronische Bauelemente z.B. einer Getriebesteuerung aufgenommen sein können. Um einen Bereich zwischen den beiden Leiterplattenelementen, d.h. angrenzend an den Abstandhalter, zuverlässig hermetisch abdichten zu können, wird in diesem Bereich ein Dichtring ausgebildet.

Dabei wird berücksichtigt, dass typischerweise für Leiterplattenelemente verwendete duroplastische Materialien wie beispielsweise Epoxide sich im Allgemeinen nicht oder allenfalls schlecht mit anderen Materialien mithilfe von Klebungen oder ähnlichem verbinden lassen. Daher wird vorgeschlagen, statt einer lediglich adhäsiv klebenden, kraftschlüssigen Verbindung eine formschlüssige Verbindung zwischen dem Dichtring und sowohl dem ersten als auch dem zweiten Leiterplattenelement auszubilden. Um eine solche formschlüssige Verbindung ausbilden zu können, wird einerseits an einer nach außen gerichteten Oberfläche des ersten Leiterplattenelements in einem Bereich angrenzend an dessen äußeren Umfang eine Mikrostrukturierung ausgebildet. Andererseits wird auch an dem zweiten Leiterplattenelement an einer nach außen gerichteten Oberfläche eine Mikrostrukturierung ausgebildet werden.

Unter einer solchen Mikrostrukturierung kann hierbei eine dreidimensionale Struktur mit beispielsweise zumindest zum Teil nach außen offenen Hohlräumen, Vertiefungen und / oder Hinterschneidungen mit Strukturgrößen im Nanometerbereich, beispielsweise Strukturgrößen im Bereich von 10 bis 100 Nanometer verstanden werden.

Der Dichtring kann derart ausgebildet werden, dass zumindest oberflächennahe Bereiche des Dichtrings in die Mikrostrukturierung an dem ersten beziehungsweise dem zweiten Leiterplattenelement eingreifen, um so die gewünschte formschlüssige Verbindung zwischen dem Dichtring und diesen Leiterplattenelementen zu realisieren. Durch eine derart ausgebildete nicht nur kraftschlüssige sondern formschlüssige Verbindung zwischen dem Dichtring einerseits und den beiden Leiterplattenelementen andererseits kann sichergestellt werden, dass der Dichtring langfristig zuverlässig das Deckelelement an dem Leiterplattenelement fixieren und eine Grenzfläche zwischen den beiden Elementen hermetisch abdichten kann.

Der Dichtring kann durch Anformen oder Anspritzen eines Kunststoffmaterials an die mit der Mikrostrukturierung versehenen Oberflächen der Leiterplattenelemente ausgebildet werden. Bei der Fertigung des Elektronikmoduls kann dabei der Dichtring durch Anformen oder Anspritzen eines zunächst flüssigen Kunststoffmaterials gebildet werden, das in Kavitäten oder Hinterschneidungen der Mikrostrukturierungen einfließen kann und das nachfolgend aushärten kann. Hierdurch kann in einfacher Weise die gewünschte formschlüssige Verbindung erzeugt werden.

Beispielsweise kann der Dichtring aus Kunststoff wie zum Beispiel Thermoplasten (wie Polyamid, PA 6, PA 66), Duroplasten (wie z. B. mit Siliziumdioxid gefüllte Epoxiharze), etc., einer Vergussmasse wie zum Beispiel Silikon-, Epoxidharzmassen, etc. und / oder einem Klebstoff zum Beispiel auf Epoxid-Basis sein. Insbesondere kann für den Dichtring ein flüssig verarbeitbarer und dann aushärtbarer Kunststoff eingesetzt werden. Solche Materialien sind einerseits verhältnismäßig einfach verarbeitbar und kostengünstig, können andererseits jedoch auch eine langfristig hermetische Abdichtung sowie eine ausreichende Resistenz gegenüber aggressiven Medien bewirken.

Der Dichtring kann durch verschiedene Verfahren ausgebildet werden. Beispielsweise kann der Dichtring durch Thermoplastspritzen, das heißt durch ein Umspritzen mit einem thermoplastischen Kunststoff, ausgebildet werden. Alternativ kann der Dichtring durch Duroplastmolding, das heißt durch Umformen mit einem duroplastischen Kunststoff, gebildet werden, beispielsweise drucklos oder mit Druck wie zum Beispiel beim Transfermolden. Als weitere Alternative kann eine Vergussmasse in einen hierfür vorgesehenen Zwischenraum zwischen dem Leiterplattenelement und dem Deckelelement eingefüllt und anschließend ausgehärtet werden. Auch ein Verkleben des Leiterplattenelements mit dem Deckelelement mithilfe eines geeigneten Klebstoffs, der zum Beispiel Silikon-, Epoxidharz-, PUR / EP-basiert oder ähnliches sein kann, ist vorstellbar.

Die Leiterplattenelemente können als handelsübliche Leiterplatten z.B. aus duroplastischem Kunststoff wie z.B. mit Glasfasern verstärktem Epoxidharz ausgebildet sein. Solche duroplastischen Materialien werden häufig als Trägermaterial für Leiterplatten eingesetzt und können insbesondere vorteilhafte Eigenschaften aufweisen, die sie als geeignet für eine Anwendung bei Elektronikmodulen für Kraftfahrzeuge erscheinen lassen. Insbesondere können duroplastische Kunststoffe chemisch stabil und resistent gegen aggressive Medien sein und hohen Temperaturen sowie starken Temperaturschwankungen widerstehen.

Der Abstandhalter kann ebenfalls aus Kunststoff bestehen, beispielsweise Thermoplast, Duroplast oder ähnlichem. Er kann als einfaches Spritzgussteil gebildet sein. Der Abstandhalter weist eine ringförmige Gestalt auf, so dass er den zwischen den beiden zu beabstandenden Leiterplattenelementen gebildeten Zwischenraum an dessen Rändern umschließen kann, um so den für die Aufnahme der elektronischen Bauelemente vorzusehenden zentralen Hohlraum vollständig zu umhüllen.

Die zur Erzielung der gewünschten formschlüssigen Verbindung mit dem Dichtring an den beiden Leiterplattenelementen vorzusehende Mikrostrukturierung kann durch unterschiedliche Verfahren ausgebildet werden.

Beispielsweise kann eine Mikrostrukturierung durch Laserstrukturierungstechniken ausgebildet werden. Hierbei wird ein Laserstrahl auf die zu strukturierenden Oberflächen gerichtet. Durch dessen Absorption kann das dort vorhandene Material stark erhitzt und letztendlich zumindest lokal verdampft werden. Durch geeignetes lokales Bestrahlen der zu strukturierenden Oberflächen können somit die gewünschten Vertiefungen, Kavitäten und/oder Hinterschneidungen für die Mikrostrukturierung gebildet werden. Zur Laserstrukturierung können z.B. leistungsschwache Laser mit einer Laserleistung von bis zu 100 Watt eingesetzt werden, wie sie z. B. auch als Beschriftungslaser eingesetzt werden, aber auch Ultrakurzpulslaser.

Alternativ kann die Mikrostrukturierung auch durch chemisches Aufrauen, mechanisches Aufrauen und / oder Plasmaaufrauen, das heißt indem die zu strukturierende einem hochenergetischen Plasma ausgesetzt wird, erzeugt werden. Hierzu kann eine handelsübliche Plasmareinigungsanlage verwendet werden, die z. B. mit Wasser, Wasserstoff, Sauerstoff, Wasserstoffperoxid oder Umgebungsluft arbeitet.

Bei dem vorgeschlagenen Elektronikmodul kann es insbesondere vorteilhaft sein, den Dichtring derart auszubilden, dass er nach außen hin freiliegt. Ein solcher nach außen hin freiliegender Dichtring kann, nachdem die beiden Leiterplattenelemente und der Abstandhalter entsprechend angeordnet wurden, einfach von außen her angeformt, beispielsweise angespritzt, werden. Die Mikrostrukturierungen an den Leiterplattenelementen liegen dabei vor dem Ausbilden des Dichtrings auch nach außen hin frei, d.h. sind außerhalb des zentralen Hohlraums angeordnet.

Gemäß einer Ausführungsform kann das erste Leiterplattenelement erste elektrische Anschlüsse aufweisen, die mit dem wenigstens einen elektronischen Bauelement elektrisch verbunden sind, und das zweite Leiterplattenelement kann zweite elektrische Anschlüsse aufweisen, die mit dem wenigstens einen elektrischen Bauelement elektrisch verbunden sind. Die ersten elektrischen Anschlüsse können hierbei mit den zweiten elektrischen Anschlüssen über Leitungen elektrisch verbunden sein. Auf diese Weise können die auf dem ersten Leiterplattenelement vorgesehenen elektronischen Bauteile mit den auf dem zweiten Leiterplattenelement vorgesehenen elektrischen Bauteilen verschaltet werden.

Insbesondere können die ersten elektrischen Anschlüsse mit den zweiten elektrischen Anschlüssen innerhalb des zentralen Hohlraums über Pressfit-Verbindungen und/oder Federkontakte elektrisch verbunden sein. Die als verbindende elektrische Leitung dienenden Pressfit-Verbindungen bzw. Federkontakte sind somit gegen einen Angriff durch umgebende aggressive Medien geschützt.

Alternativ können die ersten elektrischen Anschlüsse mit den zweiten elektrischen Anschlüssen außerhalb des zentralen Hohlraums über elektrische Leitungen, die in dem Dichtring verlaufen, elektrisch verbunden sein. Die Leitungen können dabei zwischen dem ersten und dem zweiten Leiterplattenelement in der Nähe des Umfangs des ersten Leiterplattenelements angeordnet werden, bevor der Dichtring z.B. durch Umspritzen dieses Bereichs gebildet wird. Beim anschließenden Umspritzen werden die Leitungen dann in das noch flüssige Material des Dichtrings eingebettet.

Es kann vorteilhaft sein, eines oder beide Leiterplattenelements und/oder den Abstandhalter mit einer metallischen Schicht als Diffusionssperre auszustatten. Es wurde beobachtet, dass die für die Leiterplattenelemente oder den Abstandhalter verwendbaren Kunststoffe nicht immer vollständig dicht gegenüber aggressiven Medien sind. Insbesondere können manche Medien durch solche Kunststoffe hindurch diffundieren. Eine zusätzliche metallische Schicht, erzeugt beispielsweise durch Abscheiden von Metall auf eine Innen- oder Außenoberfläche des jeweiligen Elements, kann ein solches Hindurchdiffundieren verhindern und somit eine hermetische Abdichtung verbessern.

Er wird darauf hingewiesen, dass mögliche Merkmale und Vorteile von Ausführungsformen der Erfindung hierin teilweise mit Bezug auf ein erfindungsgemäßes Elektronikmodul, teilweise mit Bezug auf ein erfindungsgemäßes Getriebesteuergerät und teilweise mit Bezug auf ein Verfahren zum Fertigen eines Elektronikmoduls beschrieben sind. Ein Fachmann wird erkennen, dass die beschriebenen Merkmale in geeigneter Weise ausgetauscht beziehungsweise kombiniert werden können und insbesondere auch von dem Elektronikmodul in analoger Weise auf das Herstellungsverfahren oder umgekehrt übertragen werden können, um hierdurch zu weiteren Ausführungsformen sowie gegebenenfalls Synergieeffekten gelangen zu können.

### Kurze Beschreibung der Zeichnungen

Nachfolgend werden Ausführungsformen der vorliegenden Erfindung unter Bezugnahme auf die beigefügten Zeichnungen beschrieben, wobei weder die Beschreibung noch die Zeichnungen als die Erfindung einschränkend auszulegen sind.
Fig. 1 (a), (b) veranschaulichen ein Verfahren zum Fertigen eines Elektronikmoduls sowie ein fertiges Elektronikmodul gemäß einer Ausführungsform der vorliegenden Erfindung.
Fig. 2 veranschaulicht im Querschnitt eine formschlüssige Verbindung mithilfe einer Mikrostrukturierung.
Fig. 3 (a), (b) veranschaulichen ein Verfahren zum Fertigen eines Elektronikmoduls sowie ein fertiges Elektronikmodul gemäß einer alternativen Ausführungsform der vorliegenden Erfindung.
Fig. 4 veranschaulicht ein Elektronikmodul in einer Getriebesteuerung gemäß einer Ausführungsform der vorliegenden Erfindung.
Fig. 5 veranschaulicht ein Getriebe mit einer Getriebesteuerung.

Die Figuren sind lediglich schematisch und nicht maßstabsgetreu. Gleiche Bezugszeichen bezeichnen in den unterschiedlichen Figuren gleiche oder gleichwirkende Merkmale.

### Ausführungsformen der Erfindung

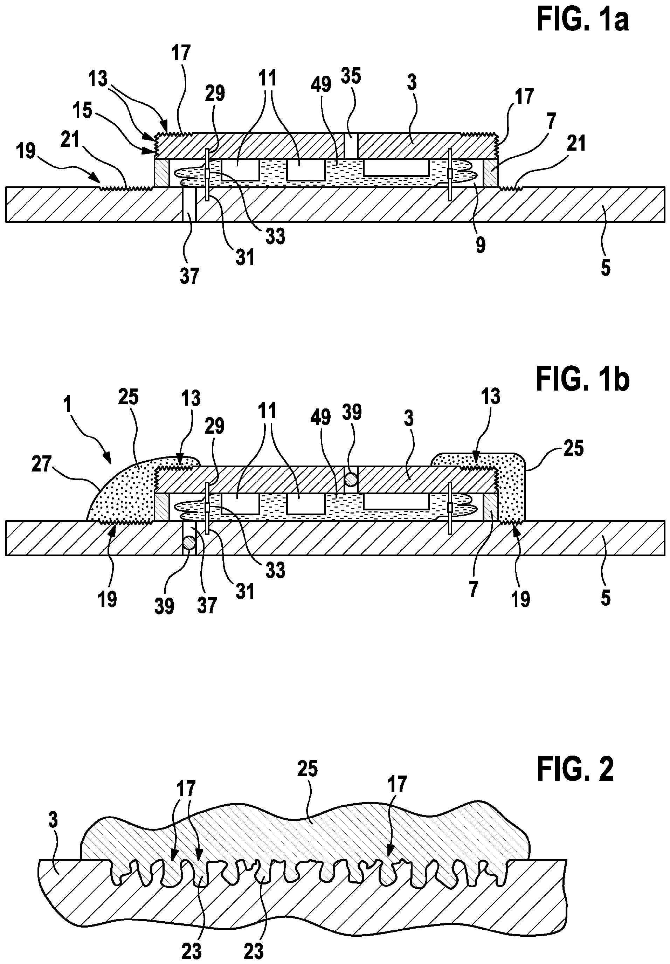

Mit Bezug auf die Figuren 1(a) und (b) wird eine Ausführungsform eines erfindungsgemäßen Elektronikmoduls 1 sowie eines Verfahrens zum Fertigen desselben beschrieben.

Zunächst werden ein erstes Leiterplattenelement 3 und ein zweites Leiterplattenelement 5 sowie ein Abstandshalter 7 bereitgestellt. Die beiden Leiterplattenelemente 3, 5 bestehen aus einem duroplastischen Kunststoff wie zum Beispiel Glasfaser-verstärktem Epoxidharz. Der Abstandhalter 7 wird als Rahmen zwischen den beiden parallel zueinander angeordneten Leiterplattenelementen 3, 5 angeordnet, so dass die Leiterplattenelemente 3, 5 zusammen mit dem ringförmigen Abstandhalter 7 einen zentralen Hohlraum 9 vollständig umhüllen. Der Abstandhalter 7 ist dabei bezüglich seiner Dicke derart bemessen, dass der zentrale Hohlraum 9 ausreichend Platz für elektronische Bauelemente 11 bietet, die an dem ersten Leiterplattenelement 3 an eine zu dem zentralen Hohlraum 9 gerichteten Oberfläche angeordnet werden.

An einer nach außen gerichteten Oberfläche 13 des ersten Leiterplattenelements 3 in der Nähe des äußeren Umfangs 15 dieses ersten Leiterplattenelements 3 wird dann beispielsweise durch Lasertexturieren eine Mikrostrukturierung 17 ausgebildet. Auch an einer benachbarten Oberfläche 19 des zweiten Leiterplattenelements 5 wird eine Mikrostrukturierung 21 ausgebildet. Wie in Figur 2 dargestellt, weisen die Mikrostrukturierungen 17, 21 eine Vielzahl von mikroskopisch kleinen Vertiefungen 23 in Form von Kavitäten oder Hinterschneidungen auf. Diese Vertiefungen haben im Allgemeinen Abmessungen im Sub-Mikrometer-Bereich und weisen zum Beispiel eine Tiefe und / oder Breite von zwischen 10 und 500 nm auf.

Die an den Leiterplattenelementen 3, 5 vorgesehenen Mikrostrukturierungen 17, 21 können nachfolgend bei einer hermetisch dichten Verkapselung der beiden Leiterplattenelemente 3, 5 miteinander helfen. Hierzu wird ein Kunststoff in Form einer nachfolgend aushärtbaren Flüssigkeit im Bereich des äußeren Umfangs 15 des ersten Leiterplattenelements 3 ringförmig umlaufend um diesen Umfang 15 beispielsweise durch Anspritzen aufgebracht. Der flüssige Kunststoff fließt dabei zumindest teilweise in die Vertiefungen 23 der Mikrostrukturierungen 17, 21. Der Abstandhalter 7 verhindert dabei, dass der flüssige Kunststoff in den zentralen Hohlraum 9 einströmt. Nach einem Aushärten des Kunststoffs bildet dieser den Dichtring 25. Der in die Vertiefungen 23 eingeflossene und dann ausgehärtete Kunststoff bildet dabei eine formschlüssige und hermetisch dichte Verbindung zwischen dem Dichtring 25 und den jeweiligen Oberflächen 13, 19 des ersten und zweiten Leiterplattenelements 3, 5.

In Figur 1(b) ist auf der linken Seite der Dichtring 25 in Form einer angespritzten "Raupe" ausgebildet. Der im flüssigen Zustand aufgebrachte Kunststoff schmiegt sich dabei an die Oberflächen 13, 19 der Leiterplattenelemente 3, 5 an und fließt in die Mikrostrukturierungen 17, 21. Eine Form einer nach außen frei liegenden Oberfläche 27 ergibt sich jedoch überwiegend zufällig. Auf der rechten Seite in Figur 1(b) wurde der Dichtring 25 mithilfe eines Werkzeugs aufgebracht, mithilfe dessen angrenzend an die zu verbindenden Oberflächen 13, 19 zunächst eine Kavität gebildet wurde, die dann mit dem flüssigen Kunststoff für den Dichtring 25 aufgefüllt wurde, wobei anschließend der Kunststoff ausgehärtet wurde, so dass sich eine vorgebbare Außengeometrie für den Dichtring 25 realisieren lässt.

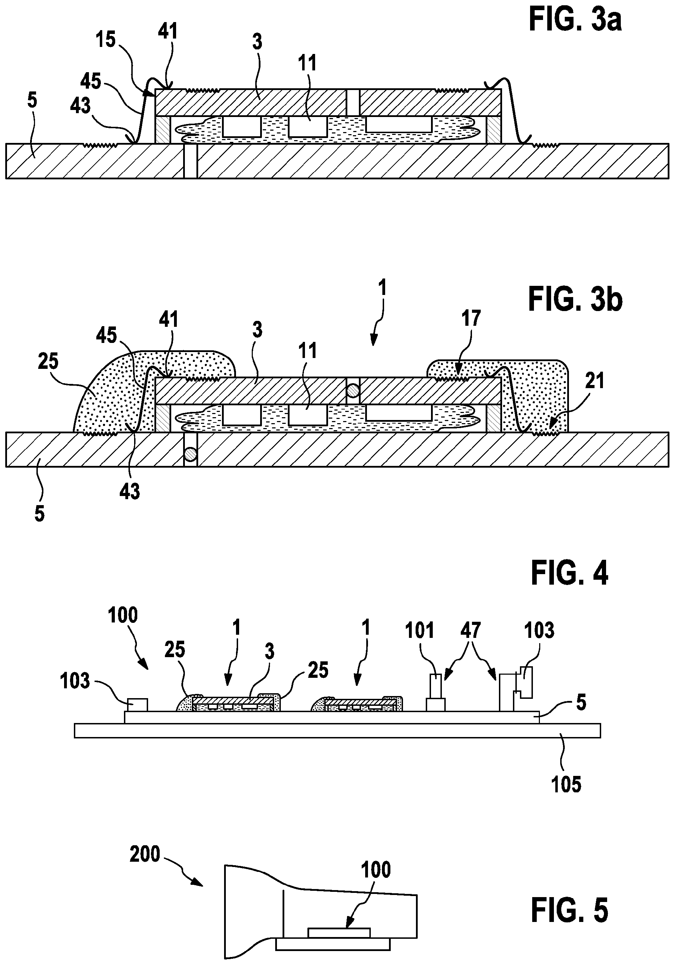

Die auf dem ersten Leiterplattenelement 3 vorgesehenen elektronischen Bauelemente 11 sind mit ersten elektrischen Anschlüssen 29 verbunden. An dem zweiten Leiterplattenelement 5 sind zweite elektrische Anschlüsse 31 vorgesehen, mit denen die an diesem zweiten Bauelement 5 vorgesehenen elektrischen Bauelemente 47 (in Figur 1 nicht dargestellt, siehe aber Figur 4) elektrisch verbunden sind. Über Pressfit-Verbindungen 33 oder über Federkontakte sind die ersten elektrischen Anschlüssen 29 mit den zweiten elektrischen Anschlüssen 31 elektrisch verbunden. Auf diese Weise können die in dem zentralen Hohlraum 9 vorgesehenen elektronischen Bauelemente 11 elektrisch mit den außerhalb dieses zentralen Hohlraums 9 vorgesehenen elektrischen Bauelementen 47 elektrisch verbunden werden.

Um die während des Betriebs der elektronischen Bauelemente 11 frei werdende Wärme besser ableiten zu können, kann abschließend durch eine Öffnung 35 ein Wärmeleitgel 49 in den zentralen Hohlraum 9 eingefüllt werden. Die beiden Leiterplattenelemente 3, 5 können thermische Vias haben, die die Wärme der Bauelemente 11 an Außenseiten der beiden Leiterplattenelemente 3, 5 leiten. Die Einfüllöffnung 35 sowie eine Entlüftungsöffnung 37 in den beiden Leiterplattenelementen 3, 5 können abschließend zum Beispiel durch ein Lot, Kleber oder einen eingepressten Stift oder eine eingepresste Kugel 39 dicht verschlossen werden.

In den Figuren 3(a) und 3(b) ist eine alternative Ausführungsform eines Elektronikmoduls 1 dargestellt. Bei dieser Ausführungsform erfolgt eine elektrische Verbindung zwischen den an dem ersten Leiterplattenelement 3 vorgesehenen elektronischen Bauteilen 11 und den an dem zweiten Leiterplattenelement 5 vorgesehenen elektrischen Bauteilen 47 nicht innerhalb des zentralen Hohlraums 9. Stattdessen erfolgt eine solche elektrische Verbindung zwischen außen liegenden elektrischen Anschlüssen 41 an dem ersten Leiterplattenelement 3 und ebenfalls außen liegenden Anschlüssen 43 an dem zweiten Leiterplattenelement 5 über elektrische Leitungen 45. Diese elektrischen Leitungen 45 können beispielsweise in Form eines Bonddrahtes, eines Flachbandkabels oder eines SMD-Jumpers vorgesehen werden. Die elektrischen Leitungen 45 können dabei nahe dem Umfang 15 des ersten Leiterplattenelements 3 angeordnet werden und anschließend beim Umspritzen dieses Umfangs 15 mit flüssigem Kunststoff zur Bildung des Dichtrings 25 mit eingegossen werden. Solche außen liegenden elektrischen Leitungen 45, insbesondere in Form von Bonds, können gegenüber den in Figur 1 dargestellten Presskontakten den Vorteil aufweisen, dass sie ohne Bohrungen in den Leiterplattenelementen 3, 5 funktionieren und somit eine einfachere Vorbereitung der Komponenten ermöglichen. Bei Bohrungen für Presskontakte sollte ein Durchgangsloch vermieden werden, damit keine Undichtigkeiten nach außen hin entstehen.

Figur 4 veranschaulicht eine Getriebesteuerung 100 mit mehreren Elektronikmodulen 1, einem als elektrisches Bauelement 47 dienenden externen Sensor 101 sowie mehreren ebenfalls als elektrische Bauelemente 47 dienenden Steckern 103. Als zweites Leiterplattenelement 5 wird hierbei diejenige Platine bezeichnet, die eine Verdrahtung der Elektronik mit elektrischen Bauelementen 47 einer Außenbeschaltung übernimmt. Bei der Getriebesteuerung 100 sind das der Sensor 101, die Stecker 103, weitere Elektroniken und Aktuatoren, usw. Das erste Leiterplattenelement 3 kann eine Leiterplatte in Form eines HDI-PCB (high identity interconnect), einer DBC (direct bonded copper), oder eines Keramiksubstrats (LTCC, HTCC, Dickschicht, usw.) sein, welche z.B. Schaltkreise für eine Elektronik einer Getriebesteuerung bilden. Hauptsächlich kann die der vorliegenden Erfindung zugrunde liegende Erfindungsidee jedoch bei PCB - zu PCB - Abdichtungen angewendet werden. Eine Trägerplatte 105 stützt die Elektronikmodule 1 mechanisch ab.

Figur 5 zeigt ein Fahrzeuggetriebe 200 mit einer darin mithilfe eines erfindungsgemäßen Elektronikmoduls ausgebildeten Getriebesteuerung 100. Die beschriebenen Elektronikmodule können jedoch auch für andere Anwendungen, beispielsweise in Motoren oder an anderen Stellen im Fahrzeug wie zum Beispiel in einem Kraftstofftank, Kühlwasser, Harnstoffanlage, Elektroantrieb, im Spritzwasserbereich, usw. eingesetzt werden.

## Patentansprüche

1. Elektronikmodul (1), aufweisend:
ein erstes Leiterplattenelement (3) mit wenigstens einem daran angeordneten elektronischen Bauelement (11); ein zweites Leiterplattenelement (5) mit wenigstens einem daran angeordneten elektrischen Bauelement (47);
einen Abstandhalter (7);
wobei das erste Leiterplattenelement (3), das zweite Leiterplattenelement (5) und der Abstandhalter (7) derart ausgebildet sind, dass sie gemeinsam einen zentralen Hohlraum (9), in dem das elektronische Bauelement (11) des ersten Leiterplattenelements (3) aufgenommen ist, vollständig umhüllen;
**dadurch gekennzeichnet, dass**
sowohl an einer nach außen gerichteten Oberfläche (13) des ersten Leiterplattenelements (3) an einem äußeren Umfang (15) des ersten Leiterplattenelements (3) als auch an einer nach außen gerichteten Oberfläche (19) des zweiten Leiterplattenelements (5) benachbart zu dem äußeren Umfang (15) des ersten Leiterplattenelements (3) jeweils ringförmig umlaufend eine Mikrostrukturierung (17, 21) ausgebildet ist, und
entlang des äußeren Umfangs (15) des ersten Leiterplattenelements (3) ein Dichtring (25) ausgebildet ist, der in formschlüssiger Verbindung sowohl mit der an dem ersten Leiterplattenelement (3) ausgebildeten Mikrostrukturierung (17) als auch in formschlüssiger Verbindung mit der an dem zweiten Leiterplattenelement (5) ausgebildeten Mikrostrukturierung (21) steht.

2. Elektronikmodul nach Anspruch 1, wobei der Dichtring (13) durch Anformen eines Kunststoffmaterials an die mit der Mikrostrukturierung (17, 21) versehenen Oberflächen des ersten Leiterplattenelements (3) und des zweiten Leiterplattenelements (5) ausgebildet ist.

3. Elektronikmodul nach Anspruch 1 oder 2, wobei das erste Leiterplattenelement (3) und/oder das zweite Leiterplattenelement (5) aus duroplastischem Kunststoff besteht.

4. Elektronikmodul nach einem der Ansprüche 1 bis 3, wobei der Dichtring (25) aus Kunststoff, Vergussmasse und/oder Klebstoff besteht.

5. Elektronikmodul nach einem der Ansprüche 1 bis 4, wobei der Dichtring (25) nach außen hin freiliegt.

6. Elektronikmodul nach einem der Ansprüche 1 bis 5, wobei das erste Leiterplattenelement (3) erste elektrische Anschlüsse (29) aufweist, die mit dem wenigstens einen elektronischen Bauelement (11) elektrisch verbunden sind, und wobei das zweite Leiterplattenelement (5) zweite elektrische Anschlüsse (31) aufweist, die mit dem wenigstens einen elektrischen Bauelement (47) elektrisch verbunden sind, und wobei die ersten elektrischen Anschlüsse (29) mit den zweiten elektrischen Anschlüssen (31) über Leitungen (33, 45) elektrisch verbunden sind.

7. Elektronikmodul nach Anspruch 6, wobei die ersten elektrischen Anschlüsse (29) mit den zweiten elektrischen Anschlüssen (31) innerhalb des zentralen Hohlraums (9) über Pressfit-Verbindungen (33) und/oder Federkontakte elektrisch verbunden sind.

8. Elektronikmodul nach Anspruch 6, wobei die ersten elektrischen Anschlüsse (29) mit den zweiten elektrischen Anschlüssen (31) außerhalb des zentralen Hohlraums (9) über elektrische Leitungen (45), die in dem Dichtring (25) verlaufen, elektrisch verbunden sind.

9. Getriebesteuergerät (100) für eine Kraftfahrzeug, aufweisend ein Elektronikmodul (1) gemäß einem der Ansprüche 1 bis 8.

10. Verfahren zum Fertigen eines Elektronikmoduls (1), aufweisend:
Bereitstellen eines ersten Leiterplattenelements (3), eines zweiten Leiterplattenelements (5) und eines Abstandhalters (7),
wobei das erste Leiterplattenelement (3), das zweite Leiterplattenelement (5) und der Abstandhalter (7) derart ausgebildet sind, dass sie gemeinsam einen zentralen Hohlraum (9), in dem ein elektronisches Bauelement (11) des ersten Leiterplattenelements (3) aufzunehmen ist, vollständig umhüllen;
**dadurch gekennzeichnet, dass** das Verfahren ferner aufweist:
Ausbilden einer ringförmig umlaufenden Mikrostrukturierung (17, 21) sowohl an einer nach außen gerichteten Oberfläche (13) des ersten Leiterplattenelements (3) an einem äußeren Umfang (15) des ersten Leiterplattenelements (3) als auch an einer nach außen gerichteten Oberfläche (19) des zweiten Leiterplattenelements (5) benachbart zu dem äußeren Umfang (15) des ersten Leiterplattenelements (3);
Anordnen wenigstens eines elektronischen Bauelements (11) an einer zu dem zentralen Hohlraum (9) gerichteten Oberfläche des ersten Leiterplattenelements (3); und
Ausbilden eines Dichtrings (25) entlang des äußeren Umfangs (15) des ersten Leiterplattenelements (3) derart, dass der Dichtring (25) in formschlüssiger Verbindung sowohl mit der an dem ersten Leiterplattenelement (3) ausgebildeten Mikrostrukturierung (17) als auch in formschlüssiger Verbindung mit der an dem zweiten Leiterplattenelement (5) ausgebildeten Mikrostrukturierung (21) steht.

11. Verfahren nach Anspruch 10, wobei die Mikrostrukturierung (17, 21) durch wenigstens ein Verfahren ausgewählt aus der Gruppe umfassend Laserstrukturieren, chemisches Aufrauen, mechanisches Aufrauen und Plasmaaufrauen ausgebildet wird.

12. Verfahren nach Anspruch 10 oder 11, wobei der Dichtring (25) durch wenigstens ein Verfahren ausgewählt aus der Gruppe umfassend Thermoplastspritzen, Duroplastmolden, Verkleben und Einfüllen einer Vergussmasse ausgebildet wird.

## Claims

1. Electronic module (1), having:
a first circuit board element (3) having at least one electronic component (11) arranged thereon;
a second circuit board element (5) having at least one electronic component (47) arranged thereon;
a spacer (7);
the first circuit board element (3), the second circuit board element (5) and the spacer (7) being configured in such a way that together they fully enclose a central cavity (9) in which the electronic component (11) of the first circuit board element (3) is received;
**characterized in that**
microstructuring (17, 21) in each case extending around in the shape of a ring is formed both on an outwardly directed surface (13) of the first circuit board element (3), on an outer circumference (15) of the first circuit board element (3), and on an outwardly directed surface (19) of the second circuit board element (5), next to the outer circumference (15) of the first circuit board element (3), and
a sealing ring (25), which is both connected with a form fit to the microstructuring (17) formed on the first circuit board element (3) and is connected with a form fit to the microstructuring (21) formed on the second circuit board element (5), is formed along the outer circumference (15) of the first circuit board element (3).

2. Electronic module according to Claim 1, wherein the sealing ring (13) is formed by molding a plastic material onto the surfaces, provided with the microstructuring (17, 21), of the first circuit board element (3) and of the second circuit board element (5).

3. Electronic module according to Claim 1 or 2, wherein the first circuit board element (3) and/or the second circuit board element (5) consists of a thermosetting plastic.

4. Electronic module according to one of Claims 1 to 3, wherein the sealing ring (25) consists of a plastic, encapsulation compound and/or adhesive.

5. Electronic module according to one of Claims 1 to 4, wherein the sealing ring (25) is exposed outward.

6. Electronic module according to one of Claims 1 to 5, wherein the first circuit board element (3) has first electrical terminals (29), which are electrically connected to the at least one electronic component (11), and wherein the second circuit board element (5) has second electrical terminals (31), which are electrically connected to the at least one electrical component (47), and wherein the first electrical terminals (25) are electrically connected to the second electrical terminals (31) via lines (33, 45).

7. Electronic module according to Claim 6, wherein the first electrical terminals (29) are electrically connected to the second electrical terminals (31) inside the, central cavity (9) by means of press-fit connections (33) and/or spring contacts.

8. Electronic module according to Claim 6, wherein the first electrical terminals (29) are electrically connected to the second electrical terminals (31) outside the central cavity (9) by means of electrical lines (45), which extend through the sealing ring (25).

9. Transmission control unit (100) for a motor vehicle, having an electronic module (1) according to one of Claims 1 to 8.

10. Method for producing an electronic module (1), comprising:
provision of a first circuit board element (3), a second circuit board element (5) and a spacer (7), the first circuit board element (3), the second circuit board element (5) and the spacer (7) being configured in such a way that together they fully enclose a central cavity (9) in which an electronic component (11) of the first circuit board element (3) is received;
**characterized in that** the method further comprises:
formation of microstructuring (17, 21) extending around in the shape of a ring both on an outwardly directed surface (13) of the first circuit board element (3), on an outer circumference (15) of the first circuit board element (3), and on an outwardly directed surface (19) of the second circuit board element (5), next to the outer circumference (15) of the first circuit board element (3);
arranging at least one electronic component (11) on a surface of the first circuit board element (3) facing toward the central cavity (9); and
formation of a sealing ring (25) along the outer circumference (15) of the first circuit board element (3), such that the sealing ring (25) is both connected with a form fit to the microstructuring (17) formed on the first circuit board element (3) and is connected with a form fit to the microstructuring (21) formed on the second circuit board element (5).

11. Method according to Claim 10, wherein the microstructuring (17, 21) is formed by at least one method selected from the group comprising laser structuring, chemical roughening, mechanical roughening and plasma roughening.

12. Method according to Claim 10 or 11, wherein the sealing ring (25) is formed by at least one method selected from the group comprising thermoplastic injection molding, thermoset injection molding, adhesive bonding and filling with an encapsulation compound.

## Revendications

1. Module électronique (1), comportant :
un premier élément de carte de circuit imprimé (3) comportant au moins un composant électronique disposé sur celui-ci ;
un deuxième élément de carte de circuit imprimé (5) comportant au moins un composant électrique disposé sur celui-ci (47) ;
un écarteur (7) ;
dans lequel le premier élément de carte de circuit imprimé (3), le deuxième élément de carte de circuit imprimé (5) et l'écarteur (7) sont réalisés de manière à ce qu'ils enveloppent ensemble entièrement une cavité centrale (9) dans laquelle est reçu le composant électronique (11) du premier élément de carte de circuit imprimé (3) ;
**caractérisé en ce qu'**une microstructuration (17, 21) est respectivement réalisée circonférentiellement de manière annulaire sur une surface dirigée vers l'extérieur (13) du premier élément de carte de circuit imprimé (3), sur une circonférence extérieure (15) du premier élément de carte de circuit imprimé (3), ainsi que sur une surface dirigée vers l'extérieur (19) du deuxième élément de carte de circuit imprimé (5) de manière adjacente à la circonférence extérieure (15) du premier élément de carte de circuit imprimé (3), et **en ce qu'**une bague d'étanchéité (25) est réalisée le long de la circonférence extérieure (15) du premier élément de carte de circuit imprimé (3), laquelle bague d'étanchéité est reliée par complémentarité de forme à la microstructuration (17) réalisée sur le premier élément de carte de circuit imprimé (3) et est également reliée par complémentarité de forme à la microstructuration (21) réalisée sur le deuxième élément de carte de circuit imprimé (5).

2. Module électronique selon la revendication 1, dans lequel de la bague d'étanchéité (13) est réalisée par moulage d'une matière plastique sur les surfaces pourvues de la microstructuration (17, 21) du premier élément de carte de circuit imprimé (3) et du deuxième élément de carte de circuit imprimé (5).

3. Module électronique selon la revendication 1 ou 2, dans lequel le premier élément de carte de circuit imprimé (3) et/ou le deuxième élément de carte de circuit imprimé (5) est constitué de matière plastique thermodurcissable.

4. Module électronique selon l'une quelconque des revendications 1 à 3, dans lequel la bague d'étanchéité (25) est/sont constituée(s) de matière plastique, d'une masse coulée et/ou d'adhésif.

5. Module électronique selon l'une quelconque des revendications 1 à 4, dans lequel la bague d'étanchéité (25) est exposée vers l'extérieur.

6. Module électronique selon l'une quelconque des revendications 1 à 5, dans lequel le premier élément de carte de circuit imprimé (3) comporte des premières bornes électriques (29) qui sont électriquement reliées à l'au moins un composant électronique (11), et dans lequel le deuxième élément de carte de circuit imprimé (5) comporte des deuxièmes bornes électriques (31) qui sont électriquement reliées à l'au moins un composant électrique (47), et dans lequel les premières bornes électriques (29) sont électriquement reliées aux deuxièmes bornes électriques (31) par l'intermédiaire de conducteurs (33, 45).

7. Module électronique selon la revendication 6, dans lequel les premières bornes électriques (29) sont électriquement reliées aux deuxièmes bornes électriques (31) à l'intérieur de la cavité centrale (9) par l'intermédiaire de liaisons par ajustage par pression (33) et/ou de contacts à ressorts.

8. Module électronique selon la revendication 6, dans lequel les premières bornes électriques (29) sont électriquement reliées aux deuxièmes bornes électriques (31) à l'extérieur de la cavité centrale (9) par l'intermédiaire de conducteurs électriques (45) qui s'étendent dans le bague d'étanchéité (25).

9. Appareil de commande de transmission (100) destiné à un véhicule automobile, comportant un module électronique (1) selon l'une quelconque des revendications 1 à 8.

10. Procédé de fabrication d'un module électronique (1), consistant à :
fournir un premier élément de carte de circuit imprimé (3), un deuxième élément de carte de circuit imprimé (5) et un écarteur (7), dans lequel le premier élément de carte de circuit imprimé (3), le deuxième élément de carte de circuit imprimé (5) et l'écarteur (7) sont réalisés de manière à ce qu'ils enveloppent ensemble entièrement une cavité centrale (9) dans laquelle doit être reçu un composant électronique (11) du premier élément de carte de circuit imprimé (3) ;
**caractérisé en ce que** le procédé consiste en outre à :
réaliser circonférentiellement de manière annulaire une microstructuration (17, 21) sur une surface dirigée vers l'extérieur (13) du premier élément de carte de circuit imprimé (3), sur une circonférence extérieure (15) du premier élément de carte de circuit imprimé (3), ainsi que sur une surface dirigée vers l'extérieur (19) du deuxième élément de carte de circuit imprimé (5) de manière adjacente à la circonférence extérieure (15) du premier élément de carte de circuit imprimé (3) ;
disposer au moins un composant électronique (11) sur une surface dirigée vers la cavité centrale (9) du premier élément de carte de circuit imprimé (3) ;
et réaliser une bague d'étanchéité (25) le long de la circonférence extérieure (15) du premier élément de carte de circuit imprimé (3) de manière à ce que la bague d'étanchéité (25) soit reliée par complémentarité de forme à la microstructuration (17) réalisée sur le premier élément de carte de circuit imprimé (3) et soit également reliée par complémentarité de forme à la microstructuration (21) réalisée sur le deuxième élément de carte de circuit imprimé (5).

11. Procédé selon la revendication 10, dans lequel la microstructuration (17, 21) est réalisée par au moins un procédé sélectionné dans le groupe comprenant la structuration au laser, l'abrasion chimique, l'abrasion mécanique et l'abrasion par plasma.

12. Procédé selon la revendication 10 ou 11, dans lequel la bague d'étanchéité (25) est réalisée par au moins un procédé sélectionné dans le groupe comprenant la pulvérisation d'un matériau thermoplastique, le moulage d'un matériau thermodurcissable, le collage et l'introduction d'une masse coulée.
